# EUROPEAN PATENT SPECIFICATION

(11) **EP 2 657 295 B1**
(45) Date of publication and mention of the grant of the patent: **03.01.2018**
(21) Application number: 11850217.8
(22) Date of filing: 03.09.2011
(51) Int. Cl.: C08L 63/00, C08L 79/08, C08L 79/04, C08L 63/02, C08L 63/04, C08G 59/40, C08J 5/24, C08K 5/521, C08K 5/5399, B32B 27/04, H05K 1/03

(54) **HALOGEN-FREE HIGH-TG RESIN COMPOSITION AND PREPREG AND LAMINATE FABRICATED BY USING THE SAME**
HALOGENFREIE HARZZUSAMMENSETZUNG MIT HOHER TG SOWIE DARAUS HERGESTELLTES PREPREG UND DARAUS HERGESTELLTES LAMINAT
COMPOSITION DE RÉSINE SANS HALOGÈNE ET DE TG ÉLEVÉE ET PRÉIMPRÉGNÉ ET STRATIFIÉ FABRIQUÉS À L'AIDE DE CELLE-CI

(30) Priority: 23.12.2010 CN 201010602885
(43) Date of publication of application: 30.10.2013
(73) Proprietor: Guangdong Shengyi Sci. Tech Co., Ltd, Dongguan, Guangdong 523000 (CN)
(72) Inventor: SU, Shiguo, Guangdong 523000 (CN); HE, Yueshan, Guangdong 523000 (CN)
(74) Representative: Plougmann Vingtoft a/s
(86) International application number: PCT/CN2011/079306
(87) International publication number: WO 2012/083727

(56) References cited:
- WO-A1-00/71614
- WO-A1-2005/118604
- WO-A1-2010/078689
- CN-A- 101 418 204
- CN-A- 101 684 191
- CN-A- 102 134 375
- JP-A- 2001 294 689
- JP-A- 2004 182 851
- JP-A- 2009 024 056
- US-A1- 2003 003 305
- LIN H T ET AL: "An approach to develop high-Tg epoxy resins for halogen-free copper clad laminates", POLYMER, ELSEVIER SCIENCE PUBLISHERS B.V, GB, vol. 50, no. 24, 16 November 2009 (2009-11-16), pages 5685-5692, XP026756517, ISSN: 0032-3861, DOI: 10.1016/J.POLYMER.2009.09.075 [retrieved on 2009-10-02]
- HUNG TSE LIN ET AL: "An approach to develop high-Tg epoxy resins for halogen-free copper clad laminates", MICROSYSTEMS PACKAGING ASSEMBLY AND CIRCUITS TECHNOLOGY CONFERENCE (IMPACT), 2010 5TH INTERNATIONAL, IEEE, PISCATAWAY, NJ, USA, 20 October 2010 (2010-10-20), pages 1-4, XP031858631, ISBN: 978-1-4244-9783-6
- RONGHUI HUANG ET AL.: 'Preparation of a High-performance Halogen-Free/Lead-Free Copper Clad Laminate' COPPER FOIL & LAMINATE no. 4, 2010, pages 28 - 30, XP008171063
- JUNQI TANG ET AL.: 'A Copper Clad Laminate for IC Packaging' INSULATING MATERIALS 1058-1170 vol. 43, no. 5, 2010, pages 11 - 13, XP055133757

## Description

### Technical field

The present invention relates to a resin composition, in particular to a halogen-free high-Tg (glass transition temperature) resin composition, prepreg and laminated fabricated by using the same.

### Background art

Polytriazine prepared from bi- or multi-functional aromatic cyanates has a high Tg, excellent dielectric properties and coefficient of thermal expansion, and is generally applied in HDI multi-layer PCB and packaging substrates. The popular BT copper-clad plate on the market is prepared from bismaleimide-triazine resin, generally and primarily bromine-containing flame retardant. With the acceleration development of environmental protection consciousness, phosphor-based flame retardants will replace the conventional bromine-based flame retardants. However, phosphor-based flame retardants are easy to absorbing water to results in measling of the sheet materials.

In addition, although only heating is required to solidify the raw materials above, a catalytically effective amount of transition metal compounds are generally needed, *e.g*. cobalt acetyl acetate, copper acetyl acetate or zinc octoate. Since these compounds are toxic and/or environmentally hazardous (especially eliminating the material fabricated by using the same) and may have an effect on the electromagnetic property, they are not the desirable raw materials.

In order to solve said problem, benzoxazine resin is introduced. Although JP2004182851 has disclosed blending cyanate, benzoxazine, epoxy resin to obtain a formulation composition, benzoxazine resin is easy to opening the loop when heated, to produce a large amount of hydroxyl groups, to cause the reaction of the by-products and to affect the cyclization of cyanates and finally affect the performances of the sheet materials. Thus the present invention uses as the resin benzoxazine resin having a greater steric hindrance and a slower reactivity, wherein hydroxyl groups produced by solidification may accelerate the cyclization of cyanates, so as to greatly reduce the consumption of the transition metals. In addition, benzoxazine has a certain flame retardant resistance, and can also achieve flame retarding resistance when used in combination with a suitable amount of phosphor-containing flame retardant, without any problems, such as the sheet materials and phosphor-containing flame retardant being easy to moisture absorption, measling and sharp reduction of physical properties, *e.g.* flexural modulus. Meanwhile, benzoxazine *per se* has a low water absorption, an excellent heat resistance and a better electric property.

### Contents of the invention

The object of the present invention lies in providing a halogen-free high-Tg resin composition, into which a certain amount of benzoxazine resin is added and used together with styrene-maleic anhydride oligomers as a curing agent of the resin, so as to improve the water absorption, heat resistance and electrical property of the resin composition.

Another object of the present invention lies in providing a prepreg fabricated by using the halogen-free high-Tg resin composition, having a low dielectric constant, a low dielectric loss constant, a high glass transition temperature, a low water absorption and a high heat resistance.

Another object of the present invention lies in providing a laminate fabricated by using the halogen-free high-Tg resin composition, having a low dielectric constant, a low dielectric loss constant, a high glass transition temperature, a low water absorption and a high heat resistance. In order to achieve the objects above, the present invention provides a halogen-free high-Tg resin composition according to claim 1. The phosphor content in the halogen-free high-Tg resin composition is preferably controlled within 1-5 wt.%; the nitrogen content thereof is preferably controlled within 1-5 wt.%.
The halogen content in the halogen-free high-Tg resin composition is preferably controlled below 0.09 wt.%. The present invention further provides a prepreg fabricated by using the halogen-free high-Tg resin composition, comprising a base material and the halogen-free high-Tg resin composition adhered to the base material after impregnation drying, wherein the base material is a nonwoven fabric or other fabrics.

The present invention further provides a laminate fabricated by using the halogen-free high-Tg resin composition, comprising several laminated prepregs, each of which comprises a base material and the halogen-free high-Tg resin composition adhered to the base material after impregnation drying.
The present invention has the following beneficial effects. (1) The halogen-free high-Tg resin composition of the present invention involves resin reacting cyante resin with benzoxazine and epoxy resin to form a triazine structure and has a low CTE, a high Tg and an excellent dielectric property. (2) The halogen-free high-Tg resin composition of the present invention uses as the resin benzoxazine resin having a greater steric hindrance and a slower reactivity, wherein hydroxyl groups produced by solidification may accelerate the cyclization of cyanates, so as to greatly reduce the consumption of the transition metals. In addition, benzoxazine has a certain flame retardant resistance, and can also achieve flame retarding resistance when used in combination with a suitable amount of phosphor-containing flame retardant, without any problems, such as the sheet materials and phosphor-containing flame retardant being easy to moisture absorption, measling and sharp reduction of physical properties, *e.g.* flexural modulus. Meanwhile, benzoxazine *per se* has a low water absorption, an excellent heat resistance and a better electric property. (3) the addition of epoxy resin into the halogen-free high-Tg resin composition of the present invention may greatly improve the processability. Meanwhile, imidazole is used as the curing accelerator to control the reaction speed of said resin composition by the amount change. (4) The prepreg and laminate fabricated from the halogen-free high-Tg resin composition of the present invention have a low dielectric constant, a low dielectric loss constant, a high heat resistance and a low water absorption, so as to overcome the defects of the current halogen-free high-Tg copper-clad plate, such as low heat resistance, worse humidity resistance, worse processability, difficult to adapt to the welding process of the current lead-free solder, and thus being applicable to a multi-layer circuit board.

### Embodiments

The present invention provides a halogen-free high-Tg resin composition, comprising, based on parts by weight of organic solids,
(A) 10-50 parts by weight of at least one cyanate and prepolymer of cyanate;
(B) 10-50 parts by weight of at least one compound having a dihydrobenzoxazine ring;
(C) 10-50 parts by weight of at least one bismaleimide resin;
(D) 10-50 parts by weight of at least one polyepoxy compound; and
(E) 5-30 parts by weight of at least one phosphorus-containing flame
retardant.

The ingredients are detailedly explained as follows.

The ingredient (A) in the present invention is the cyanate and prepolymer of cyanate, which may further improve the thermal and electrical characteristics of the polymers and articles. The cyanate and prepolymer of cyanate is selected from the group consisting of the prepolymers formed from the compounds of formulae (I), (II) and (III) and one or more compounds above, 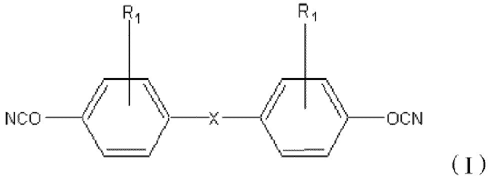 wherein R₁ in formula (I) represents H, alkane, alkene or alkyne; X is selected from the group consisting of -CH₂-, -CH(CH₃)-, -C(CH₃)₂-, -C(CF₃)₂-, -O-, -S-, -C(=O)-, -OC(=O)-, -OC(=O)O-, 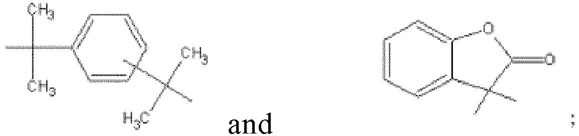 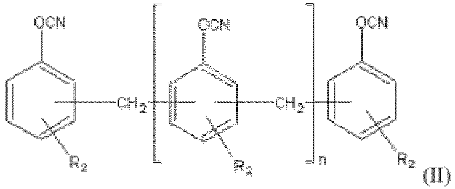 wherein n in formula (II) is any integer from 0-10, and R₂ is H or methyl; and 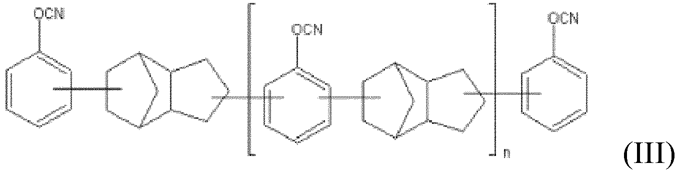 wherein n in formula (III) is any integer from 0-10.

The ingredient (A) may be the mixture of these compounds, prepolymers of these compounds, prepolymers of the mixture of these compounds, and the mixture of the prepolymers of these compounds. A prepolymer may be understood an oligomer obtained by partial tripolymerization. These oligomers comprise not only triazinyl groups, but also unreacted cyanate ester groups. Cyanate ester is a known compound, and most of them are commercially available. These prepolymers are also known, and partially and commercially available or readily prepared from cyanate ester. Cyanate ester is used in an amount of 10-50 parts by weight. Too little cyanate ester cannot satisfy the required performances, such as high Tg, low CTE, low dielectric constant Dk and the like; too much cyanate ester may affect other performances of the sheet materials, such as reduced heat resistance, water absorption and the like. The optimum amount thereof is between 10-30 parts by weight.

The ingredient (B) in the present invention, *i.e*. the compound having a dihydrobenzoxazine ring, is advantageous to increasing the flame retardant property, hygroscopicity, heat resistance, mechanical performance and electrical property of the cured resin and sheet materials fabricated by using the same. The selected benzoxazine resin, *i.e.* the compound having a dihydrobenzoxazine ring, is selected from the group consisting of the prepolymers formed from the compounds of formulae (IV), (V) and (VI) and one or more compounds above, 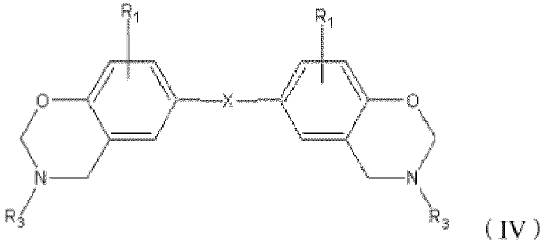 wherein R₁ in formula (IV) represents H, alkane, alkene or alkyne; X is selected from the group consisting of -CH₂-, -CH(CH₃)-, -C(CH₃)₂-, -C(CF₃)₂-, -O-, -S-, -C(=O)-, -OC(=O)-, -OC(=O)O-, 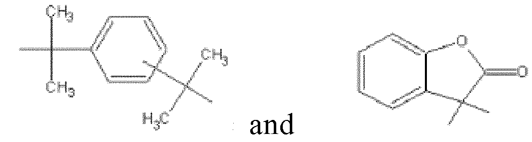 wherein R₃ represents methyl or phenyl group; 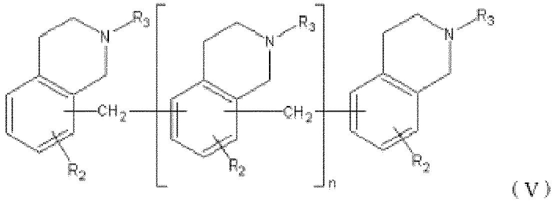 wherein n in formula (V) is any integer from 0-10; R₂ is H or methyl; R₃ represents methyl or phenyl group; 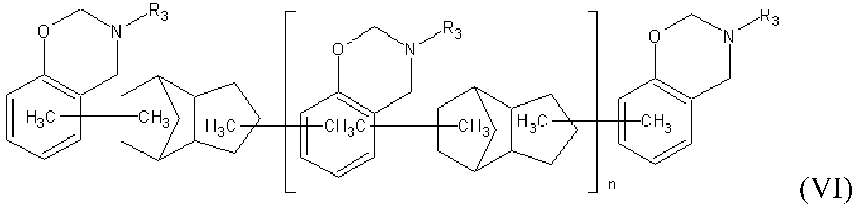 wherein n in formula (VI) is any integer from 0-10; R₃ represents methyl or phenyl group.

The benzoxazine resin with side chain, alkane, olefinic bond, alkyne, arene is characterized by a greater steric hindrance and a slow reactivity. Thus said three resins are preferably used in the present invention. The benzoxazine resin may be used alone or in combination in an amount of preferably from 10-50 parts by weight, most preferably from 10 to 40 parts by weight.

The ingredient (C) in the present invention, *i.e*. the bismaleimide resin, has a high heat resistance, a dimensional stability and excellent electrical property required for encapsulating sheet materials. The bismaleimide resin is selected from the group consisting of the prepolymers formed from the compounds of formula (VII) and one or more compounds above,

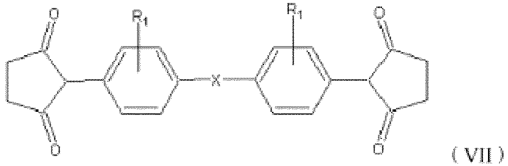

Wherein R₁ represents H, alkane, alkene or alkyne. The bismaleimide resin may be used alone or in combination in an amount of preferably from 10-50 parts by weight, most preferably from 20 to 45 parts by weight.

The ingredient (D) in the present invention, *i.e*. the polyepoxy compound, enables the cured resin and the base plate fabricated by using the same to achieve the required basic mechanical and thermal performances. Diglycidyl ether epoxy resin is the better choice. The polyepoxy compound comprises (1) bifunctional epoxy resin, comprising biphenol A-type epoxy resin, biphenol F-type epoxy resin and the like; (2) novolac epoxy resin, comprising phenol-type novolac epoxy resin, orthocresol novolac epoxy resin, biphenol A-type novolac epoxy resin, dicyclopentadiene phenol-type epoxy resin; (3) phosphorus-containing epoxy resin, comprising 9,10-dihydro-9-ova-10-phosphaphenanthrene-10-oxide modified epoxy resin, 10-(2,5-dihydroxyphenyl)-9,10-dihydro-9-ova-10-phosphaphenanthrene-10-oxide modified epoxy resin, 10-(2,9-dihydroxynaphthyl)-9,10-dihydro-9-ova-10-phosphaphenanthrene-10-oxide. Said epoxy resins may be used alone or in combination according to the use thereof. For example, the condensate has a better toughness when biphenol F-type epoxy resin is used; the condensate has a higher glass transition temperature when phenol-type novolac epoxy resin or orthocresol novolac epoxy resin is used; the phosphor ingredient required for flame retardanting is provided by using phosphorus-containing epoxy resin. The epoxy resin is used in an amount of preferably from 10-50 parts by weight, most preferably from 20 to 45 parts by weight.

The ingredient (E) of the present invention, *i.e*. the phosphorus-containing flame retardant, is used to increase the combustion performance of the cured resin and the base plate fabricated by using the same. The phosphorus-containing flame retardant used therein is at least one compound selected from the group consisting of phosphate and compounds thereof, phenoxylphosphonitrile compounds, phosphaphenanthrenes and derivatives thereof. The phosphorus-containing flame retardant not reducing the dielectric constant is the better one, and the preferred phosphorus-containing flame retardant comprises phenoxylphosphonitrile compounds, phosphate compounds and the like. The phosphorus-containing flame retardant may be used alone or in combination according to the synergistic flame retarding effect. The phosphorus-containing flame retardant is used in the present invention in an amount of 5-30 parts by weight. If the amount thereof is less than 5 parts by weight, the flame retarding effect cannot be achieved; if the amount thereof is higher than 30 parts by weight, other performances of the sheet materials will be affected, such as reduced processability, water absorption, bending strength and the like. The phosphor content in the halogen-free high-Tg resin composition is controlled within 1-5 wt.%; the nitrogen content thereof is controlled within 1-5 wt.%.

The halogen-free high-Tg resin composition of the invention further comprises a catalyst and a curing accelerator. The catalyst includes the compounds selected from the group consisting of metal carboxylates, phenols, alcohols, urea derivatives, imidazoles, metal chelates and mixtures thereof, preferably metal carboxylates, *e.g*. acetyl acetone acid metal salts, or imidazol, wherein the elemental metal is selected from the group consisting of zinc, cobalt, copper, manganese, iron, nickel, aluminium and mixtures thereof. The curing accelerator may be any known accelerator capable of speeding up the solidification of thermosetting resins. The suitable accelerator is selected form the group consisting of various imidazols, tertiary amines, quaternary amines and the like, *e.g.* 2-methylimidazole, 2-ethyl-4-methylimidazole, 2-phenylimidazole, 2-hendecylimidazole, benzyl dimethylamine, 2,4,6-tri(dimethylinmethyl)-phenol (DMP-30) and the like.

In the present invention, the well known additives, such as thermoplastic resins, inorganic bulking agents, coloring pigments, antifoaming agents, surface conditioning agents, flame retardants, UV absorbents, antioxidants, flowing adjustment agents and the like, may be added as required. Inorganic bulking agents are primarily used to adjust some physical property effect of the composition, *e.g*. reducing CTE, increasing thermal conductivity and the like. The fillers may be silica (including crystalline-, melting-, and spheroidal silica), kaolin, boron nitride, aluminium nitride, alumina, glass fibers, silicon carbide, polytetrafluoroethylene and the like, and one or more of said fillers may be suitably chosen as required. The optimal filler is silica; the moderate value of the particle size of the fillers ranges from 1-15 µm, preferably from 1-10 µm, wherein the fillers having a particle size falling within such range have a better dispersibility. The amount of the fillers is preferably 10-200% of the total weight of the organic solids in the halogen-free high-Tg resin composition.

The prepreg fabricated by using the halogen-free high-Tg resin composition in the invention comprises a base material and the halogen-free high-Tg resin composition adhered to the base material after impregnation drying, wherein the base material is a nonwoven fabric or other fabrics, *e.g*. natural fibers, organic synthetic fibers and inorganic fibers. The halogen-free high-Tg resin composition of the invention is conventionally prepared by firstly adding solids, then adding a liquid solvent, stirring to complete dissolution, then adding a liquid resin and an accelerator, continuing to stir to a well balance, finally and suitably adjusting with PM (propylene glycol methyl ether) solvent the solid content of the solution to 60-70% to form a liquid cement, impregnating fabrics or organic fabrics such as glass cloth with such liquid cement, heating and drying the impregnated glass cloth in an oven having a temperature of 160°C for 3-6 minutes, to prepare a prepreg.

The laminate fabricated by using the halogen-free high-Tg resin composition in the present invention comprises several laminated prepregs, each of which comprises a base material and the halogen-free high-Tg resin composition adhered to the base material after impregnation drying. During the preparation of the laminate, two or more pieces of prepregs are adhered together by heating or compression, wherein said laminate may be adhered to metal foils at either or both sides, so as to fabricate metal foil clad laminate. In the examples of the present invention, 8 pieces of prepregs and 2 pieces of one ounce of metal foils are laminated together, laminated by hot press to compress a double-side metal foil clad laminate. Said laminate should necessarily satisfy the following requirements: (1) the temperature increasing rate of the lamination should be generally controlled at 1.5-2.5°C/min when the material temperature ranges from 80-140°C; (2) the pressure setup of the lamination: a full pressure of about 350 psi is applied when the outside material temperature ranges from 80-100°C; (3) the material temperature is controlled at 195°C during the curing for 90 minutes. Said metal foils are copper foils, nickel foils, aluminium foils and SUS foils and the like, and the materials are not limited.

The dielectric constant, dielectric loss constant, heat resistance, water absorption, glass transition temperature, flame retarding resistance of the laminate fabricated above are measured, and further detailed stated and described in the following examples.

### See Examples 1-4 and Comparative Examples 1-2

The examples of the present invention are detailedly stated as follows, but the present invention is not limited within the scope of the examples. Unless otherwise specified, the part represents the weight part, and the % represents "wt.%".
(A) Cyanate and prepolymer thereof
(A-1) PRIMASET PT15 (LongSa brand name)
(B) Compounds having dihydrobenzoxazine
(B-1) LZ8282 (Huntsman Advanced Materials)
(B-2) Allyl bisphenol A benzoxazine (provided by Sichuan university)
(C) Bismaleimide resin
   BMI-01 (Wuhan Honghu brand name)
(D) Polyepoxy compound
(D-1) NC3000L (DIC)
(D-2) XZ92530 (DOW CHEMICALS)
(E) Phosphor-containing flame retardant
(E-1) PX-200 (Daihachi Chemical Industry Co.,Ltd)
(E-2) XZ92741 (DOW CHEMICALS)
(F) Catalyst
(F-1) 2-methyl-4-ethylimidazole (SHIKOKU CHEMICALS CORPORATION)
(F-2) Zinc octoate
(G) Fillers

Spherical silicon micropowder (having an average particle size of 1-10 µm and a purity of more than 99%)

**Table 1 Formulation of the compositions in Examples 1-4 and Comparative Examples 1-2 (parts by weight)**

| | Example 1 | Example 2 | Example 3 | Example 4 | Comparative Example 1 | Comparative Example 2 |
|---|---|---|---|---|---|---|
| A | 44 | 30 | 16 | 48 | 40 | 65 |
| B-1 | 12 | | 44 | | | 10 |
| B-2 | | 18 | | 8 | | |
| C | 16 | 24 | 28 | 16 | 20 | 10 |
| D-1 | 18 | | 12 | | 30 | 15 |
| D-2 | | 25 | | 28 | | |
| E-1 | | 3 | | 5 | | 10 |
| E-2 | 10 | | 10 | 5 | 10 | |
| F | | | | | | |
| F-1 | 0.1 | | 0.1 | 0.1 | | 0.2 |
| F-2 | 0.008 | 0.013 | | | 0.022 | |
| G | 100 | 120 | 80 | 150 | 100 | 100 |

**Table 2 Characteristic evaluation**

| | Example 1 | Example 2 | Example 3 | Example 4 | Comparative Example 1 | Comparative Example 2 |
|---|---|---|---|---|---|---|
| Glass transition temperature (°C) | 203 | 195 | 198 | 196 | 200 | 220 |
| Peeling strength | 1.30 | 1.25 | 1.28 | 1.27 | 1.30 | 1.27 |
| Burning resistance | V-0 | V-0 | V-0 | V-0 | V-0 | V-0 |
| Soldering resistance (delamination) | O | O | O | O | O | O |
| Soldering resistance (white plague) | O | O | O | O | O | O |
| Water absorption (%) | 0.22 | 0.21 | 0.20 | 0.29 | 0.6 | 0.7 |
| Dielectric constant (1GHz) | 4.4 | 4.1 | 4.5 | 4.0 | 4.6 | 4.1 |
| Dielectric loss (1GHz) | 0.006 | 0.005 | 0.006 | 0.005 | 0.006 | 0.006 |
| CTE (30-260°C) | 2.8 | 3.0 | 2.7 | 2.8 | 2.8 | 2.6 |
| Halogen content (%) | 0.03 | 0.03 | 0.03 | 0.03 | 0.03 | 0.03 |

The above characteristics are measured by the following methods.

### (a) Glass transition temperature (°C)

In accordance with the differential scanning calorimetry, the DSC method stipulated under IPC-TM-650 2.4.25 is conducted for measurement.

### (b) Peeling strength

According to the test conditions of "after thermal stress" in the method in accordance with IPC-TM-650 2.4.8, the peeling strength of the metal cover coat is tested.

### (c) Burning resistance

In accordance with UL94

### (d) Soldering resistance

The samples (the basis material having a size of 100x100 mm) which remained in pressure cooking device (121°C, 105 Kpa) for 2 hours were impregnated in a solder bath heated to 260°C for 20 seconds, to observe with eyes (h1) presence of delamination, (h2) presence of white plaque or wrinkling. O in the table represents no change; Δ represents white plaque; x represents delamination.

### (e) Water absorption (%)

In accordance with IPC-TM-650 2.6.2.1

### (f) Dielectric constant and Dielectric loss (1GHz)

According to the resonance method of using strip lines, dielectric loss and dielectric loss factor at 1 GHz are measured in accordance with IPC-TM-650 2.5.5.5

### (g) Thermal Expansion Coefficient (CTE)

In accordance with IPC-TM-650 2.4.24, the Z-axle CTE of the printing plate and insulated base materials was measured.

### (h) Halogen content (%)

In accordance with JPCA-ES-01-2003 halogen-free copper clad plate test method, halogen content of the copper clad foil laminate was measured by the oxygen flask combustion and ion chromatography.

According to the results above, it can be seen that the present invention can achieve the efficacy of a low dielectric constant, a low dielectric loss factor, a high glass transition temperature, a burning resistance, a Soldering resistance and a water absorption. Meanwhile, the processability, halogen content of the sheet materials fall within the halogen-free requirement scope under JPCA and can achieve the V-0 standard in fire resistance test UL94. The halogen-free high-Tg resin composition of the present invention sufficiently utilizes the synergistic properties of cyanate resins, benzoxazine resin, bismaleimide resins and epoxy resins, wherein the halogen content is less than 0.09%, so as to achieve the environmental protection efficacy. The printed circuit board fabricated from the halogen-free high-Tg resin composition of the present invention not only has the equivalent mechanical performance and heat resistance to the general FR-4 printed circuit board, but also has an excellent high-Tg dielectric performance and can meet the requirements of high Tg transmission system on the printed circuit board.

The aforesaid examples are only the optimal examples of the present invention. As for those ordinarily skilled in the art, various other corresponding changes and deformations can be made on the basis of the technical solutions and technical concepts of the present invention, wherein all these changes and deformations should fall within the protection scope of the claims of the present invention.

## Claims

1. A halogen-free high-Tg resin composition, comprising, based on parts by weight of organic solids:
(A) 10-50 parts by weight of at least one cyanate and prepolymer of cyanate, wherein the cyanate and prepolymer of cyanate is selected from the group consisting of the prepolymers formed from the compounds of formulae (I), (II) and (III) and one or more compounds above, 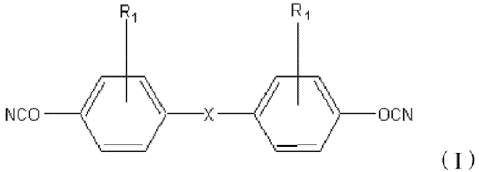 wherein R₁ in formula (I) represents H, alkane, alkene or alkyne; X is selected from the group consisting of -CH2-, -CH(CH3)-, -C(CH3)2-, -C(CF3)2-, -O-, -S-, -C(=O)-, -OC(=O)-, -OC(=O)O-, 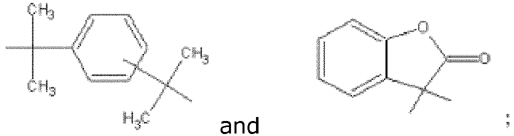 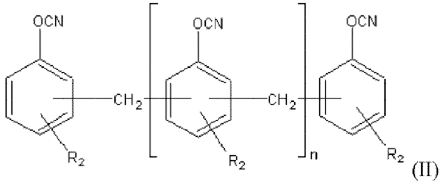 wherein n in formula (II) is any integer from 0-10, and R₂ is H or methyl; and 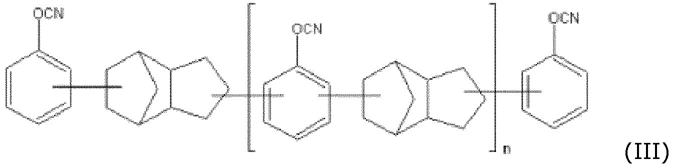 wherein n in formula (III) is any integer from 0-10;
(B) 10-50 parts by weight of at least one compound having a dihydrobenzoxazine ring, wherein the compound having a dihydrobenzoxazine ring is selected from the group consisting of the prepolymers formed from the compounds of formulae (IV), (V) and (VI) and one or more compounds above, 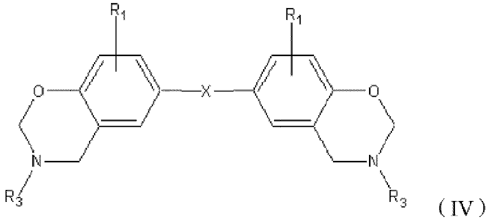 wherein R₁ in formula (IV) represents alkane, alkene or alkyne; X is selected from the group consisting of -CH2-, -CH(CH3)-, -C(CH3)2-, -C(CF3)2-, -O-, -S-, -C(=O)-, -OC(=O)-, -OC(=O)O-, 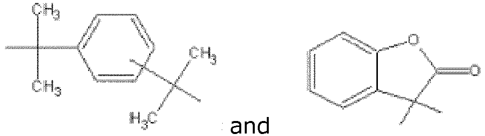 wherein R₃ represents methyl or phenyl group; 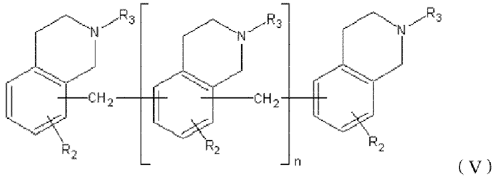 wherein n in formula (V) is any integer from 0-10; R₂ is H or methyl; R₃ represents methyl or phenyl group; 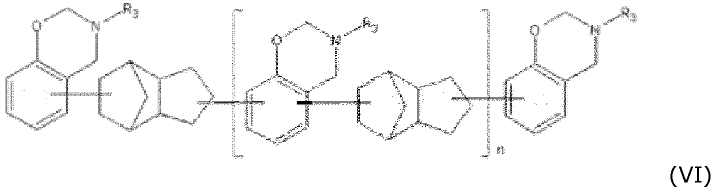 wherein n in formula (VI) is any integer from 0-10; R₃ represents methyl or phenyl group;
(C) 10-50 parts by weight of at least one bismaleimide resin, wherein the bismaleimide resin is selected from the group consisting of the prepolymers formed from the compounds of formula (VII) and one or more compounds above, 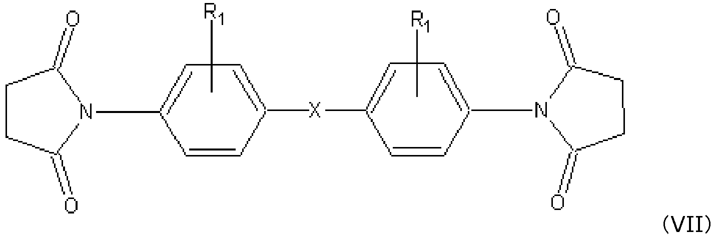 wherein R₁ represents H, alkane, alkene or alkyne, and wherein X has the above defined meaning;
(D) 10-50 parts by weight of at least one polyepoxy compound, wherein the polyepoxy compound comprises at least one compound selected from the group consisting of
(1) bifunctional epoxy resin, comprising biphenol A-type epoxy resin, biphenol F-type epoxy resin, biphenyl-type epoxy resin;
(2) novolac epoxy resin, comprising phenol-type novolac epoxy resin, biphenol A-type novolac epoxy resin, orthocresol novolac epoxy resin, dicyclopentadiene phenol-type epoxy resin;
(3) phosphorus-containing epoxy resin, comprising 9,10-dihydro-9-ova-10-phosphaphenanthrene-10-oxide modified epoxy resin, 10-(2,5-dihydroxyphenyl)-9,10-dihydro-9-ova-10-phosphaphenanthrene-10-oxide modified epoxy resin, 10-(2,9-dihydroxynaphthyl)-9,10-dihydro-9-ova-10-phosphaphenanthrene-10-oxide; and
(E) 5-30 parts by weight of at least one phosphorus-containing flame retardant, wherein the phosphorus-containing flame retardant is at least one compound selected from the group consisting of phosphate and compounds thereof, phenoxylphosphonitrile compounds, phosphaphenanthrenes and derivatives thereof.

2. The halogen-free high-Tg resin composition according to claim 1, wherein the phosphor content in the halogen-free high-Tg resin composition is controlled within 1-5 wt.%; the nitrogen content thereof is controlled within 1-5 wt.%.

3. The halogen-free high-Tg resin composition according to claim 1, wherein the halogen content in the halogen-free high-Tg resin composition is controlled below 0.09 wt.%.

4. A prepreg fabricated by using the halogen-free high-Tg resin composition according to claim 1, comprising a base material and the halogen-free high-Tg resin composition adhered to the base material after impregnation drying, wherein the base material is a nonwoven fabric or other fabrics.

5. A laminate fabricated by using the halogen-free high-Tg resin composition according to claim 1, comprising several laminated prepregs, each of which comprises a base material and the halogen-free high-Tg resin composition adhered to the base material after impregnation drying.

## Patentansprüche

1. Halogenfreie Harzzusammensetzung mit hoher Tg, die Folgendes basierend auf Gewichtsteilen von organischen Feststoffen umfasst:
(A) 10-50 Gewichtsteile von zumindest einem Cyanat und Vorpolymer von Cyanat, wobei das Cyanat und Vorpolymer von Cyanat ausgewählt ist aus der Gruppe bestehend aus den Vorpolymeren, die aus dem Verbindungen von Formel (I), (II) und (III) und einer oder mehreren vorstehenden Verbindungen gebildet sind, 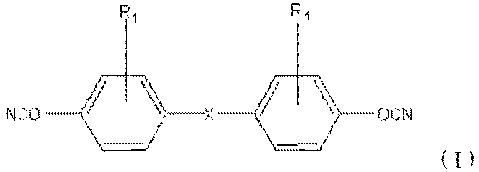 wobei R₁ in Formel (I) für H, Alkan, Alken oder Alkyn steht; X ausgewählt ist aus der Gruppe bestehend aus -CH2-, -CH(CH3)-, -C(CH3)2-, -C(CF3)2-, -O-, -S-, -C(=O)-, -OC(=O)-, -OC(=O)O-, 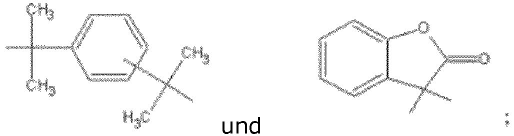 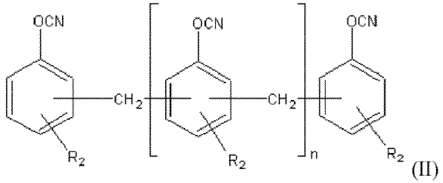 wobei n in Formel (II) jede ganze Zahl von 0-10 ist, und R₂ H oder Methyl ist; und 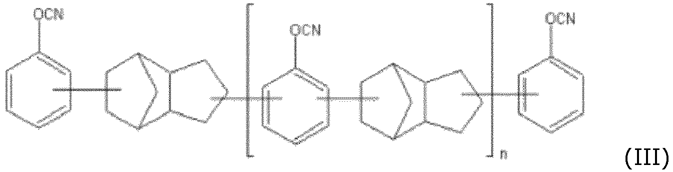 wobei n in Formel (III) jede ganze Zahl von 0-10 ist;
(B) 10-50 Gewichtsteile von zumindest einer Verbindung mit einem Dihydrobenzoxazinring, wobei die Verbindung mit einem Dihydrobenzoxazinring ausgewählt ist aus der Gruppe bestehend aus den Vorpolymeren, die aus den Verbindungen von Formel (IV), (V) und (VI) und einer oder mehreren der vorstehenden Verbindungen gebildet sind, 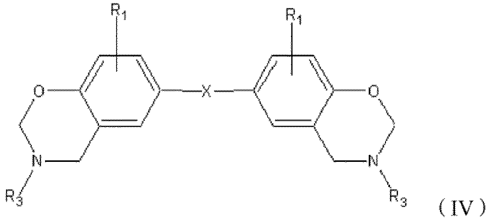 wobei R₁ in Formel (IV) für Alkan, Alken oder Alkyn steht; X ausgewählt ist aus der Gruppe bestehend aus -CH2-, -CH(CH3)-, -C(CH3)2-, -C(CF3)2-, -O-, -S-,-C(=O)-, -OC(=O)-, -OC(=O)O-, 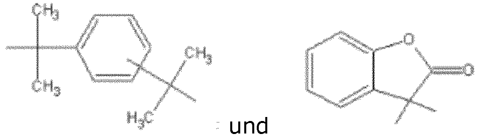 wobei R₃ für Methyl- oder Phenylgruppe steht; 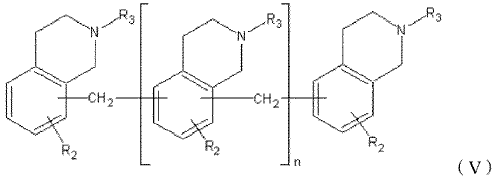 wobei n in Formel (V) jede ganze Zahl von 0-10 ist; R₂ H oder Methyl ist; R₃ für Methyl- oder Phenylgruppe steht; 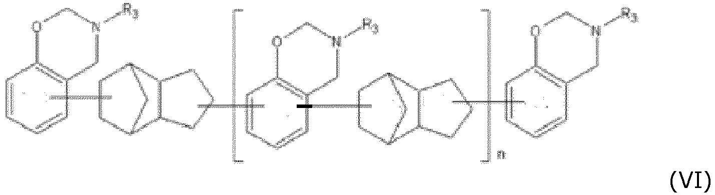 wobei n in Formel (VI) jede ganze Zahl von 0-10 ist; R₃ für Methyl- oder Phenylgruppe steht;
(C) 10-50 Gewichtsteile von zumindest einem Bismaleimidharz, wobei das Bismaleimidharz ausgewählt ist aus der Gruppe bestehend aus den Vorpolymeren, die aus den Verbindungen von Formel (VII) und einer oder mehreren der vorstehenden Verbindungen gebildet sind, 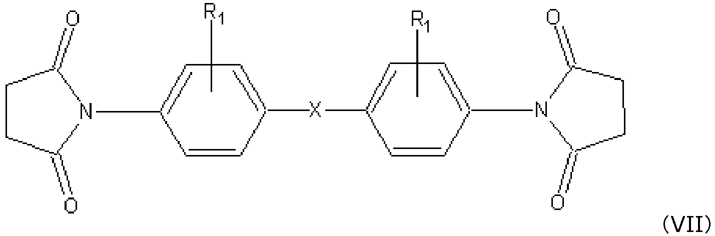 wobei R₁ für H, Alkan, Alken oder Alkyn steht, und wobei X die vorstehend definierte Bedeutung hat;
(D) 10-50 Gewichtsteile von zumindest einer Polyepoxidverbindung, wobei die Polyepoxidverbindung zumindest eine Verbindung umfasst, die aus der Gruppe bestehend aus Folgendem ausgewählt ist:
(1) bifunktionales Epoxidharz, umfassend Epoxidharz vom Biphenol-A-Typ, Epoxidharz vom Biphenol-F-Typ, Epoxidharz vom Biphenyl-Typ;
(2) Novolakepoxidharz, umfassend Novolakepoxidharz vom Phenol-Typ, Novolakepoxidharz vom Biphenol-A-Typ, Orthocresol-Novolakepoxidharz, Epoxidharz vom Dicyclopentadien-Phenol-Typ;
(3) phosphorhaltiges Epoxidharz, umfassend 9,10-Dihydro-9-ova-10-phosphaphenanthren-10-oxid-modifiziertes Epoxidharz, 10-(2,5-Dihydroxyphenyl)-9,10-dihydro-9-ova-10-phosphaphenanthren-10-oxid-modifiziertes Epoxidharz, 10-(2,9-Dihydroxynaphthyl)-9,10-dihydro-9-ova-10-phosphaphenanthren-10-oxid; und
(E) 5-30 Gewichtsteile von zumindest einem phosphorhaltigen Flammschutzmittel, wobei das Flammschutzmittel zumindest eine Verbindung ist, ausgewählt aus der Gruppe bestehend aus Phosphat und Verbindungen davon, Phenoxylphosphonitril-Verbindungen, Phosphaphenanthrenen und Derivaten davon.

2. Halogenfreie Harzzusammensetzung mit hoher Tg nach Anspruch 1, wobei der Phosphorgehalt in der halogenfreien Harzzusammensetzung mit hoher Tg auf einen Bereich innerhalb von 1-5 Gew.-% eingestellt ist; der Stickstoffgehalt davon auf einen Bereich innerhalb von 1-5 Gew.-% eingestellt ist.

3. Halogenfreie Harzzusammensetzung mit hoher Tg nach Anspruch 1, wobei der Halogengehalt in der halogenfreien Harzzusammensetzung mit hoher Tg auf unter 0,09 Gew.-% eingestellt ist.

4. Prepreg, hergestellt durch Verwendung der halogenfreien Harzzusammensetzung mit hoher Tg nach Anspruch 1, umfassend ein Basismaterial und die halogenfreie Harzzusammensetzung mit hoher Tg, die an dem Basismaterial nach Imprägnierungstrocknung anhaftet, wobei das Basismaterial ein nichtgewebter Stoff oder andere Stoffe ist.

5. Laminat, hergestellt durch Verwendung der halogenfreien Harzzusammensetzung mit hoher Tg nach Anspruch 1, umfassend mehrere laminierte Prepregs, von denen jedes ein Basismaterial und die halogenfreie Harzzusammensetzung mit hoher Tg, die an dem Basismaterial nach Imprägnierungstrocknung anhaftet, umfasst.

## Revendications

1. Composition de résine sans halogène et de Tg élevée comprenant, sur la base des parties en poids de solides organiques :
(A) 10 à 50 parties en poids d'au moins un cyanate et un prépolymère de cyanate, lesdits cyanate et prépolymère de cyanate étant choisis dans le groupe constitué par des prépolymères formés à partir des composés représentés par les formules (I), (II) et (III) et d'un ou plusieurs composés ci-dessus, 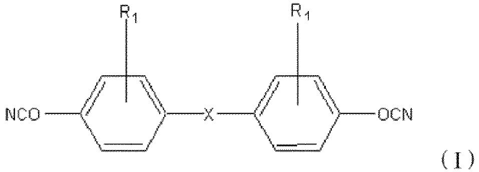 R₁ dans la formule (I) représentant un atome H, un groupe alcane, alcène ou alcyne ; X étant choisi dans le groupe constitué par les groupes -CH₂-, -CH(CH₃)-, -C(CH₃)₂-, -C(CF₃)₂-, -O-, -S-, -C(=O)-, -OC(=O)-, -OC(=O)O-, 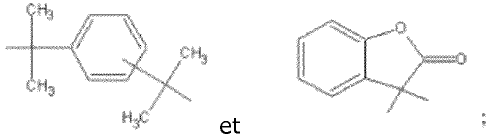 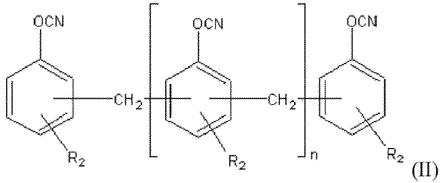 n dans la formule (II) représentant un quelconque entier de 0 à 10, et R₂ représentant un atome H ou un groupe méthyle ; et 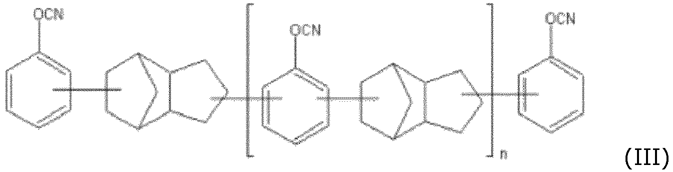 n dans la formule (III) représentant un quelconque entier de 0 à 10 ;
(B) 10 à 50 parties en poids d'au moins un composé comportant un noyau dihydrobenzoxazine, ledit composé comportant un noyau dihydrobenzoxazine étant choisi dans le groupe constitué par les prépolymères formés à partir des composés représentés par les formules (IV), (V) et (VI) et d'un ou plusieurs composés ci-dessus, 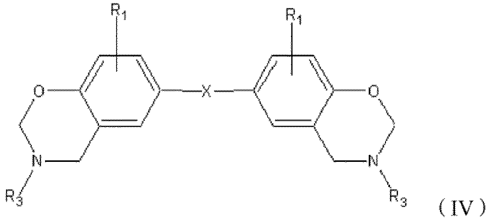 R₁ dans la formule (IV) représentant un groupe alcane, alcène ou alcyne ; X étant choisi dans le groupe constitué par les groupes -CH2-, -CH(CH3)-, -C(CH3)2-,-C(CF₃)₂-, -O-, -S-, -C(=O)-, -OC(=O)-, -OC(=O)O-, 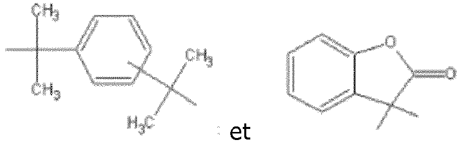 R₃ représentant un groupe méthyle ou phényle ; 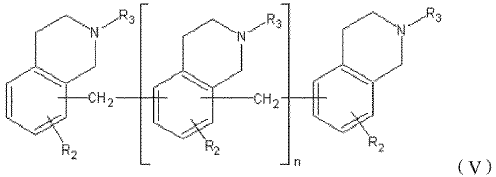 n dans la formule (V) représentant un quelconque entier de 0 à 10 ; R₂ représentant un atome H ou un groupe méthyle ; R₃ représentant un groupe méthyle ou phényle ; 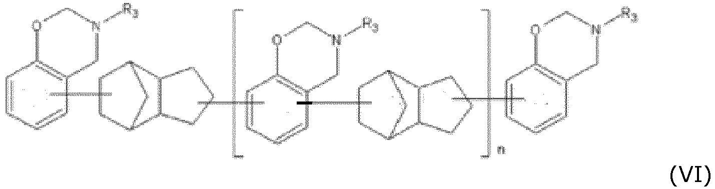 n dans la formule (VI) représentant un quelconque entier de 0 à 10 ; R₃ représentant un groupe méthyle ou phényle ;
(C) 10 à 50 parties en poids d'au moins une résine de bismaléimide, ladite résine de bismaléimide étant choisie dans le groupe constitué par les prépolymères formés à partir des composés représentés par la formule (VII) et d'un ou plusieurs composés ci-dessus, 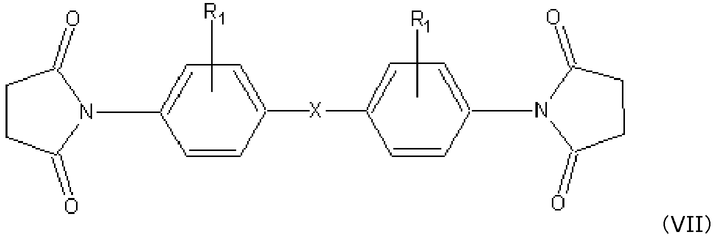 R₁ représentant un atome H, un groupe alcane, alcène ou alcyne, et X ayant la signification définie ci-dessus ;
(D) 10 à 50 parties en poids d'au moins un composé polyépoxy, ledit composé polyépoxy comprenant au moins un composé choisi dans le groupe constitué par
(1) une résine époxy bifonctionnelle, comprenant une résine époxy de type bisphénol A, une résine époxy de type bisphénol F, une résine époxy de type biphényle ;
(2) une résine époxy novolaque, comprenant une résine époxy novolaque de type phénol, une résine époxy novolaque de type bisphénol A, une résine époxy novolaque d'orthocrésol, une résine époxy de type dicyclopentadiène-phénol ;
(3) une résine époxy contenant du phosphore, comprenant une résine époxy modifiée par le 9,10-dihydro-9-ova-10-phosphaphénanthrène-10-oxyde, une résine époxy modifiée par le 10-(2,5- dihydroxyphényl)-9,10-dihydro-9-ova-10-phosphaphénanthrène-10-oxyde, une résine époxy modifiée par le 10-(2,9-dihydroxynaphtyl)-9,10-dihydro-9-ova-10-phosphaphénanthrène-10-oxyde ; et
(E) 5 à 30 parties en poids d'au moins un agent retardeur de flamme contenant du phosphore, ledit agent retardeur de flamme contenant du phosphore étant au moins un composé choisi dans le groupe constitué par le phosphate et des composés de celui-ci, des composés de phénoxyphosphonitrile, des phosphaphénanthrènes et des dérivés de ceux-ci.

2. Composition de résine sans halogène et de Tg élevée selon la revendication 1, la teneur en phosphore dans la composition de résine sans halogène et de Tg élevée étant régulée entre 1 à 5 % en poids ; le teneur en azote de celle-ci étant régulée entre 1 à 5 % en poids.

3. Composition de résine sans halogène et de Tg élevée selon la revendication 1, la teneur en halogène dans la composition de résine sans halogène et de Tg élevée étant régulée en-dessous de 0,09 % en poids.

4. Préimprégné fabriqué à l'aide de la composition de résine sans halogène et de Tg élevée selon la revendication 1, comprenant un matériau de base et la composition de résine sans halogène et de Tg élevée collée au matériau de base après séchage par imprégnation, ledit matériau de base étant un tissu non tissé ou d'autres tissus.

5. Stratifié fabriqué à l'aide de la composition de résine sans halogène et de Tg élevée selon la revendication 1, comprenant plusieurs imprégnés stratifiés, chacun desquels comprenant un matériau de base et la composition de résine sans halogène et de Tg élevée collée au matériau de base après séchage par imprégnation.
